# EUROPEAN PATENT SPECIFICATION

(11) **EP 4 087 377 B1**
(45) Date of publication and mention of the grant of the patent: **10.07.2024**
(21) Application number: 19958401.2
(22) Date of filing: 31.12.2019
(51) Int. Cl.: H05K 7/20, B60L 58/33, B60K 11/04, B61D 27/00, B60L 3/00, B60K 1/00

(54) **COOLING DEVICE**
KÜHLVORRICHTUNG
DISPOSITIF DE REFROIDISSEMENT

(43) Date of publication of application: 09.11.2022
(73) Proprietor: Hunan Lince Rolling Stock Equipment Co., Ltd, Zhuzhou, Hunan 412001 (CN)
(72) Inventor: WU, Kai, Zhuzhou, Hunan 412001 (CN); TAN, Zhixiong, Zhuzhou, Hunan 412001 (CN); TAN, Facheng, Zhuzhou, Hunan 412001 (CN); LI, Youyu, Zhuzhou, Hunan 412001 (CN); HOU, Zhiquan, Zhuzhou, Hunan 412001 (CN)
(74) Representative: Wunderlich & Heim Patentanwälte PartG mbB
(86) International application number: PCT/CN2019/130515
(87) International publication number: WO 2021/134480

(56) References cited:
- CN-A- 102 442 199
- CN-A- 102 442 199
- CN-A- 107 323 285
- CN-U- 209 472 955
- CN-U- 209 472 955
- CN-Y- 200 988 410
- JP-A- 2006 107 969
- JP-A- 2014 151 722
- US-A1- 2012 013 185
- US-A1- 2012 085 510
- US-A1- 2015 047 814
- US-A1- 2017 259 833

## Description

### Field of the Invention

The invention relates to the technical field of Electrical Multiple Unit (EMU), in particular to a cooling device mounted on the roof of the EMU.

### Background of the Invention

Traction converters, fuel cells and reactors are the key components of a train, providing power or the like for normal operations of the train. When the train is running, components such as traction converters, fuel cells and reactors will generate a huge amount of heat, so that it is necessary to provide dedicated cooling devices for dissipating heat and reducing temperature, in order to avoid serious consequences from overheating of these specific components.

However, current cooling devices have the following disadvantages. For example, the cooling device has relatively low heat exchange efficiency and large weight. In addition, the whole cooling circuit will fail and stop working when the fan is damaged, thus affecting normal operations of the train. Moreover, the cooling device is relatively noisy. Further, the cooling effect can be barely adjusted, so that energy consumption of the cooling device cannot be precisely controlled.

For example, in US 2012/085510 A1 a cooling apparatus for a vehicle is described.

In US 2012/013185 A1 a fuel cell system including a voltage converter and a cooling water circulation flow path for cooling purposes are shown.

Furthermore, in CN 209 472 955 U a cooling system with two different cooling circuits is described.

Therefore, it is necessary to provide a more stable and reliable cooling device to solve the problems existing in the prior arts.

### Summary of the Invention

In view of at least some or all of the above problems existing in the prior arts, the present invention proposes a cooling device, which has the advantages of high heat exchange efficiency, reduced weight, low noise, and precise control on energy consumption.

According to the present invention, a cooling device is proposed, comprising: a converter cooling circuit, in which a converter radiator is arranged; a fuel cell cooling circuit, in which a fuel cell radiator is arranged; an air-cooling assembly configured to perform heat dissipation and cooling for the converter radiator and the fuel cell radiator. The converter cooling circuit is configured to dissipate heat for the converter, and the fuel cell cooling circuit is configured to dissipate heat for the fuel cell.

In a transverse direction, the converter radiator is located at a first side of the fuel cell radiator and in parallel therewith, while the air-cooling assembly is located at a second side of the fuel cell radiator, and in a longitudinal direction, the converter radiator is located at a second end of the fuel cell radiator, so that ambient air is sucked in from a first side of the converter radiator at a position corresponding to the converter radiator, and then drawn out by the air-cooling assembly after passing through the fuel cell radiator.

In the transverse direction, the converter radiator and the fuel cell radiator are spaced from each other so that a cylindrical air duct body is arranged between the converter radiator and the fuel cell radiator and in communication with both. A cleaning port is formed in an upper surface of the air duct body, and a cleaning cover is arranged at the cleaning port via a hinge.

The upper surface of the air duct body is configured as an inclined surface, which has a first side and a second side higher than the first side.

In one embodiment, the fuel cell cooling circuit further comprises: a longitudinally extending first fuel cell pipe, which is arranged upstream of the fuel cell radiator; a transversely extending second fuel cell pipe, which is in communication with the first fuel cell pipe; a transversely extending third fuel cell pipe, which is arranged downstream of the fuel cell radiator; a longitudinally extending fourth fuel cell pipe, which is in communication with the third fuel cell pipe; and a fuel cell water tank connected in parallel with the fuel cell radiator. An opening at the first end of the first fuel cell pipe is in communication with an outlet of the fuel cell, and an opening at the first end of the fourth fuel cell pipe is communication with an inlet of the fuel cell. The fuel cell water tank is located at the second end of the fuel cell radiator.

In one embodiment, a first air conditioner pipe is connected to the first fuel cell pipe or the second fuel cell pipe, and a second air conditioner pipe is connected to the first fuel cell pipe or the second fuel cell pipe at a position downstream of a connection between the first air conditioner pipe and the first fuel cell pipe or the second fuel cell pipe. The first air conditioner pipe is in communication with an inlet of the air conditioner, and the second air conditioner pipe is in communication with an outlet of the air conditioner.

In one embodiment, the converter cooling circuit further comprises a converter water tank and a converter water pump. The converter water tank is located at the first side of the fuel cell radiator along the transverse direction, and at the first end of the converter radiator along the longitudinal direction. The inverter water pump is located at the first side of the fuel cell radiator along the transverse direction, and between the inverter water tank and the inverter radiator along the longitudinal direction.

In one embodiment, a reactor upstream pipeline is arranged in parallel on a pipeline of the converter cooling circuit upstream of the converter radiator, for connecting with an outlet of the reactor. A reactor downstream pipeline is arranged in parallel on a pipeline of the converter cooling circuit downstream of the converter radiator, for connecting with an inlet of the reactor.

In one embodiment, the air-cooling assembly comprises multiple cooling fans arranged in parallel, each cooling fan being driven by a corresponding motor located at the second side in the transverse direction. Said multiple cooling fans are arranged in sequence in the longitudinal direction. The converter radiator is communication with more than one cooling fan.

In one embodiment, sound-absorbing cotton is provided on each of inner walls of a casing of the cooling fan except that with an air outlet.

In one embodiment, the cooling device further comprises a mounting frame having a longitudinally extending support beam connected to the motors, wherein the converter cooling circuit, the fuel cell cooling circuit and the cooling fans are all fixed by the mounting frame.

Compared with the prior arts, the present invention has at least one of the advantages as follows. The cooling device has two cooling circuits, and thus can provide heat dissipation and temperature reduction for different components, such as the converter and the fuel cell, thereby effectively improving the utilization rate of the cooling device. At the same time, the external dimension and weight of the cooling device can be reduced accordingly.

### Brief Description of the Drawings

Preferred embodiments of the present invention will be explained in more detail with reference to the accompanying drawings, wherein:
Fig. 1 shows a system schematic diagram of a cooling device according to an embodiment of the present invention;
Fig. 2 shows a perspective view of a cooling device according to an embodiment of the present invention;
Fig. 3 shows a front view of a cooling device according to an embodiment of the present invention;
Fig. 4 shows a top view of a cooling device according to an embodiment of the present invention;
Fig. 5 shows a rear view of a cooling device according to an embodiment of the present invention;
Fig. 6 shows a left side view of a cooling device according to an embodiment of the present invention; and
Fig. 7 shows a right side view of a cooling device according to an embodiment of the present invention.

In the drawings, the same reference numerals are used to indicate the same components. The drawings are not drawn to actual scale.

### Detailed Description of the Embodiments

The present invention will be further described below with reference to the accompanying drawings.

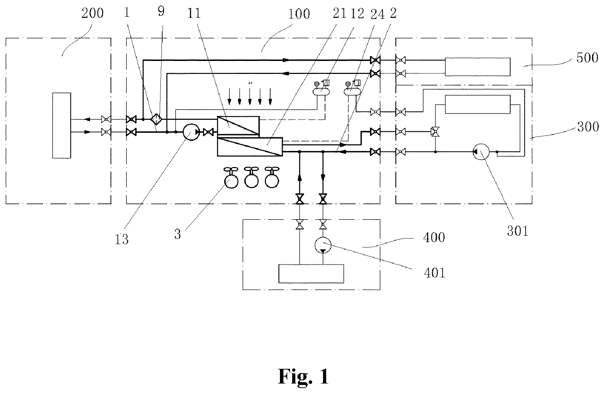

Fig. 1 shows a system schematic diagram of a cooling device 100 according to the present invention. As shown in Fig. 1, the cooling device 100 includes two cooling circuits and an air-cooling assembly 3. One of the two cooling circuits is a converter cooling circuit 1, in which coolant (for example, water) circulates to provide heat dissipation and temperature reduction for a converter 200. In the following the coolant will be described with water as an example, but it is not limited to water. The converter cooling circuit 1 is provided therein with a converter radiator 11. The other one of the two cooling circuits is a fuel cell cooling circuit 2, in which coolant (for example, water) circulates to provide heat dissipation for a fuel cell 300. In the following the coolant will be also described with water as an example, but it is not limited to water. In addition, the fuel cell cooling circuit 2 is provided therein with a fuel cell radiator 21. The air-cooling assembly 3 is used for providing heat dissipation and cooling for the converter radiator 11 and the fuel cell radiator 21. During the operation of the air-cooled assembly 3, cooling air and the coolant exchange heat with each other sufficiently to reduce the temperature of the coolant, so that the coolant can be kept in circulation to achieve temperature reduction for the converter 200, the fuel cell 300 or the like. Therefore, the cooling device 100 has two cooling circuits, which can simultaneously provide heat dissipation and temperature reduction for different components, such as the converter, the fuel cell or the like, thereby improving the heat dissipation efficiency of the cooling device 100. At the same time, based on the above principle and structure, the external dimension and weight of the cooling device 100 can be also reduced accordingly.

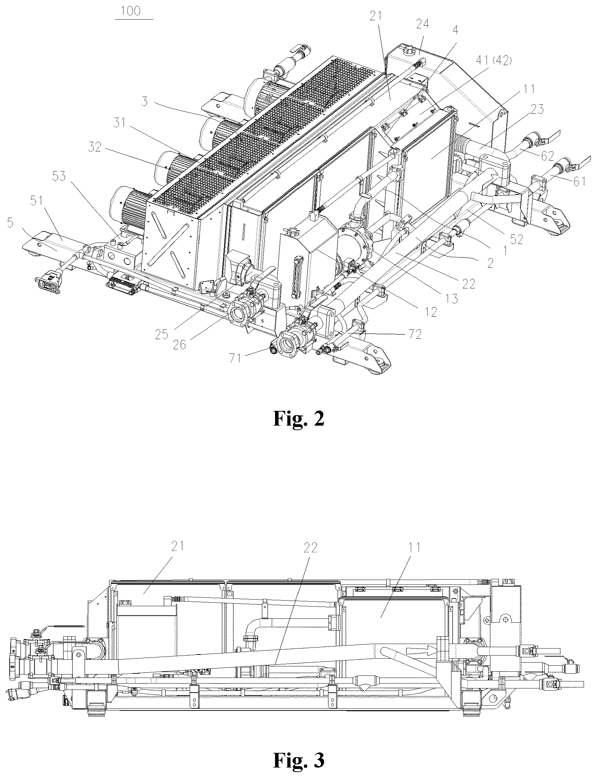

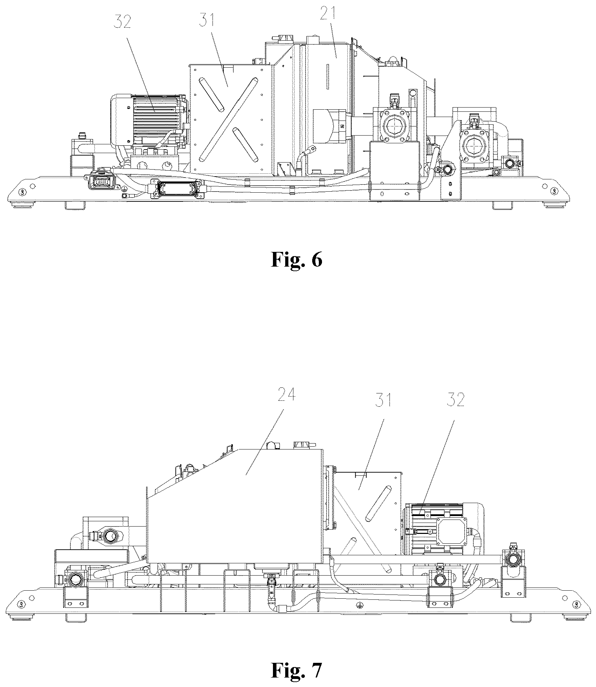

As shown in Figs. 2 to 7, the cooling device 100 includes a mounting frame 5. The mounting frame 5 mainly plays a role of supporting and fixing other components (such as the air-cooling assembly 3), so that the cooling device 100 as a whole can be mounted on the roof of a train. For example, the mounting frame 5 includes at least two transverse beams 51 disposed opposite to each other and spaced from each other, and a plurality of longitudinal beams 52 disposed between the transverse beams 51 and fixedly connected therewith.

Structurally, the converter radiator 11 and the fuel cell radiator 21 are each constructed as a generally rectangular body. In a transverse direction, the converter radiator 11 is located at a first side of the fuel cell radiator 21 and generally arranged in parallel therewith, while the air-cooling assembly 3 is located at a second side of the fuel cell radiator 21. In a longitudinal direction, the converter radiator 11 is located at a second end of the fuel cell radiator 21. That is, the converter radiator 11 and the fuel cell radiator 21 are partially overlapped with each other in the transverse direction. During the operation of the air-cooling assembly 3, ambient air is sucked in from a first side of the converter radiator 11 at a position corresponding to the converter radiator 11, and then drawn out by the air-cooling assembly 3 after passing through the fuel cell radiator 21. At other positions not being overlapped with the converter radiator 11, ambient air is sucked in from the first side of the fuel cell radiator 21, and then drawn out by the air-cooling assembly 3. In the above arrangement, the three relatively large components (i.e., the air-cooling assembly 3, the converter radiator 11 and the fuel cell radiator 21) are arranged on the mounting frame 5 along the transverse direction in a manner of substantially parallel with each other, and close to the second side. The layout is reasonable and thus advantageous to the utilization of space on the roof of the train. In addition, the above arrangement can ensure sufficient heat dissipation of the converter radiator 11 and the fuel cell radiator 21, thereby facilitating to ensure efficient heat dissipation.

Preferably, in the transverse direction, the converter radiator 11 and the fuel cell radiator 21 are spaced apart to form a gap therebetween, which has a certain size, say, 8-15 cm. An air duct body 4 is arranged in the gap for connecting the converter radiator 11 with the fuel cell radiator 21, thus ensuring that air will enter the fuel cell radiator 21 from the converter radiator 11 when being sucked by the air-cooling assembly 3. For example, the air duct body 4 may be configured to have a cylindrical shape, which corresponds to an outer wall of a housing of the converter radiator 11. In addition, a cleaning port 41 is formed in an upper surface of the air duct body 4, and a cleaning cover 42 is arranged at the cleaning port 41 via a hinge. Since the converter radiator 11 is spaced apart from the fuel cell radiator 21, it is convenient to clean the two radiators 11 and 21 respectively. Moreover, through providing the cleaning port 41 and the cleaning cover 42, it can increase convenience of the cleaning operation without affecting the cooling effect. Further preferably, the upper surface of the air duct body 4 is configured as an inclined surface, which has a first side and a second side higher than the first side, with its rotation axis extending along the longitudinal direction at the second side of the cleaning cover 42. That is, in a direction from a housing of the fuel cell radiator 21 to the housing of the converter radiator 11, the upper surface of the air duct body 4 is configured as a gradually declining slope. On the one hand, this arrangement is beneficial for cleaning the fuel cell radiator 21. On the other hand, it can ensure that the cleaning cover 42 can be tightly closed on the cleaning port 41 during sucking operation of the air-cooling assembly 3.

In a specific embodiment, the fuel cell cooling circuit 2 further includes a first fuel cell pipe 22, a second fuel cell pipe 23, a fuel cell water tank 24, a third fuel cell pipe 25 and a fourth fuel cell pipe 26. The first fuel cell pipe 22 has a longitudinally extending tubular shape, and is arranged upstream of the fuel cell radiator 21. The first fuel cell pipe 22 has an opening 28 at the first end, for connecting an outlet of the fuel cell to receive the coolant from the fuel cell 300. The second fuel cell pipe 23 is in communication with the first section fuel cell pipe 22, and extends transversely. The fuel cell water tank 24 is mounted on the transverse beam 51 arranged at the second end, and is connected in parallel with the fuel cell radiator 21. The third fuel cell pipe 25 and the fourth fuel cell pipe 26 are provided in sequence downstream of the fuel cell radiator 21. The third fuel cell pipe 25 extends transversely, while the fourth fuel cell pipe 26 extends longitudinally. The fourth fuel cell pipe 26 has an opening 29 at the first end, for connecting with an inlet of the fuel cell to deliver the cooled coolant to the fuel cell 300. During the circulation, the coolant from the fuel cell first enters the first fuel cell pipe 22 and then the second fuel cell pipe 23, and subsequently enters the fuel cell radiator 21. Under the action of the air-cooling assembly 3, water is cooled in the fuel cell radiator 21 so that its temperature is reduced. Finally, after heat dissipation and temperature reduction, the coolant enters into the third fuel cell pipe 25, and flows out through the fourth fuel cell pipe 26 to the fuel cell. The above-mentioned structure has a reasonable layout, with efficient space utilization.

With the fuel cell water tank 24 connected in parallel with the fuel cell radiator 21, coolant can be replenished to the fuel cell cooling circuit 2 and gas can be discharged from the fuel cell cooling circuit 2. For example, the fuel cell water tank 24 may be configured as a single-cavity structure. A gas collecting bag, which is, for example, bowl-shaped, is arranged on the top of the cavity, for collecting gas in the coolant entering the fuel cell water tank 24 and preventing the gas from entering into a water pump arranged in the fuel cell cooling circuit 2. In this manner, it can avoid the occurrence of cavitation, protect the fuel cell cooling circuit 2, and in particular prolong the service life of the fuel cell water pump. It should note here that, in order to realize the circulation of the coolant in the circuit, the water pump can be arranged in the cooling device 100, or can be arranged in the fuel cell 300 and an air conditioner 400, respectively. In an embodiment of the present invention, two pumps are arranged in the fuel cell 300 and in the air conditioner 400, respectively, to activate circulation of the coolant in the fuel cell cooling circuit 2. For example, a pump 301 is arranged in the fuel cell 300, while a pump 401 is arranged in the air conditioner 400.

In structure, for example, the first fuel cell pipe 22 may be an inclined pipe, so that in a direction from the first end to the second end, the first fuel cell pipe 22 is gradually elevated. In addition, a right-angle elbow joint is used to connect two pipes together, so as to increase convenience of installation. This structure not only achieves structural optimization and operational convenience, but also ensures that the gas in the fuel cell cooling circuit 2 can enter the fuel cell water tank 24 through the first fuel cell pipe 22 and the second fuel cell pipe 23. Accordingly, it facilitates to remove the gas from the coolant, and ensures safe operation of the fuel cell cooling circuit 2.

In one embodiment, a first air conditioner pipe 61 is connected to the first fuel cell pipe 22 or the second fuel cell pipe 23. The first air conditioner pipe 61 extends in the longitudinal direction, and has an opening 69 at the second end for connecting to an inlet of the air conditioner. At the same time, a second air conditioner pipe 62 is connected to the first fuel cell pipe 22 or the second fuel cell pipe 23, at a position downstream of the connection between the first air conditioner pipe 61 and the first fuel cell pipe 22 or the second fuel cell pipe 23. The second air conditioner pipe 62 extends in the longitudinal direction, and has an opening 68 at the second end for connecting to an outlet of the air conditioner. That is to say, part of the water from the first fuel cell pipe 22 will enter the air conditioner 400 through the first air conditioner pipe 61, and then flows back to the first fuel cell pipe 22 or the second fuel cell pipe 23 via the second air conditioner pipe 62 after heat exchange in the air conditioner 400. With this arrangement, the temperature difference between the fuel cell coolant and the air conditioner 400 can be further utilized, and an additional heat exchange will occur in the air conditioner 400, thereby improving the heat exchange efficiency.

The converter cooling circuit 1 further includes a converter water tank 12 and a converter water pump 13. The converter water tank 12 is arranged in parallel with the converter radiator 11, for replenishing water and collecting gas. The converter water pump 13 is arranged on a pipeline upstream of the converter radiator 11, so that the coolant from the converter 200 and the reactor 500 will enter the converter radiator 11 through the converter water pump 13. In structure, along the transverse direction, the converter water tank 12 is located at the first side of the fuel cell radiator 21, and along the longitudinal direction, the converter water tank 12 is located at the first end of the converter radiator 11. Moreover, along the transverse direction, the inverter water pump 13 is located at the first side of the fuel cell radiator 21, and along the longitudinal direction, the inverter water pump 13 is located between the inverter water tank 12 and the inverter radiator 11. That is, along the longitudinal direction at the first side of the fuel cell radiator 21, the inverter water tank 12, the inverter water pump 13 and the inverter radiator 11 are arranged in sequence in a direction from the first end to the second end. With this arrangement, on the one hand, the converter water tank 12, the converter water pump 13 and the converter radiator 11 are substantially located on a same longitudinal line, which utilizes and occupies a space formed between the first fuel cell pipe 22 and the fuel cell radiator 11, thus achieving a compact structure. On the other hand, the connections within the converter cooling circuit 1 can be simplified, the connections between pipelines can be reduced, and connecting operations can be facilitated. In particular, with the above arrangement, the converter water tank 12 and the converter water pump 13 can be both located at the first side of the fuel cell radiator 21, so that air adjacent to the converter water tank 12 and the converter water pump 13 can be driven to flow during the operation of the air-cooling assembly 3, so as to dissipate the heat for the converter water tank 12 and the converter water pump 13 both, further improving the heat dissipation efficiency.

In the converter cooling circuit 1, an opening 18 of the pipeline upstream of the converter radiator 11 is arranged at the second end, and in a position close to the second side for connecting with an outlet of the converter. At the same time, an opening 19 of the pipeline downstream of the converter radiator 11 is also arranged at the second end, and in a position close to the second side for connecting with an inlet of the converter. The coolant in the converter 200 enters the converter cooling circuit 1 through the opening 18 of the pipeline upstream of the converter radiator 11, and after passing through the converter radiator 11 for heat dissipation, enters the converter 200 via the opening 19 of the pipeline downstream of the converter radiator 11, so as to realize the circulation of the coolant for cooling the converter 200. It should note that according to actual needs, the pipelines used in the converter cooling circuit 1 for the purpose of connection can be arranged upstream or downstream of the converter radiator 11.

In one embodiment, a reactor upstream pipeline 71 is arranged in parallel on the pipeline of the converter cooling circuit 1 upstream of the converter radiator 11, for connecting with an outlet of the reactor. The reactor upstream pipeline 71 has an opening 78 at the first end. A reactor downstream pipeline 72 is arranged in parallel on the pipeline of the converter cooling circuit 1 downstream of the converter radiator 11, for connecting with an inlet of the reactor. The reactor downstream line 72 has an opening 79 at the first end. In addition, the opening 78 of the reactor upstream pipeline 71, the opening 79 of the reactor downstream pipeline 72, the opening 28 of the first fuel cell pipe 22 and the opening 29 of the fourth fuel cell pipe 26 are all located at the first end of the whole cooling device 100, and close to the first side thereof. In order to facilitate the connecting operations, the opening 78 of the reactor upstream pipeline 71 and the opening 79 of the reactor downstream pipeline 72 are vertically lower than the opening 29 of the fourth fuel cell pipe 26 and the opening 28 of the first fuel cell pipe 22, respectively. At the same time, along the transverse direction, the reactor upstream pipeline 71 is located between the first fuel cell pipe 22 and the fourth fuel cell pipe 26, while the reactor downstream pipeline 72 is located at the first side of the first fuel cell pipe 22. With the above arrangement, the converter cooling circuit 1 can provide heat dissipation for the reactor 500, thereby improving the cooling efficiency. At the same time, the above arrangement has a reasonable layout in space structure, thus enabling the installation and operation simple and convenient.

In one embodiment, the air-cooling assembly 3 includes multiple cooling fans 31 and motors 32 arranged in parallel. Each cooling fan 31 is driven by a corresponding motor 32, which is located at the second side of said cooling fan 31. For example, there may be four air-cooled assemblies 3 for enhancing the safety of operation. Even if one of the air-cooling assemblies 3 is damaged, the cooling device 100 can still work, thereby ensuring the normal operation of the train. In the above arrangement, a plurality of air-cooled assemblies 3 are arranged in parallel, and the motor 32 of each of the air-cooled assemblies 3 has two adjustment modes, i.e., high-speed and low-speed modes. Accordingly, during operation, the air-cooled assemblies 3 can be adjusted according to actual working conditions to provide a 9-level precise control on energy consumption. Moreover, the number of the air-cooled assemblies 3 can also provide various cooling forms, ensuring the most efficient energy consumption. The redundant design of the cooling fans 31 increases adjustability and reduces energy consumption.

During installation, the motors 32 are arranged on a support beam 53 of the mounting frame 5. Specifically, the support beam 53 is a flat plate extending longitudinally, with two ends thereof being fixedly connected with the transverse beams 51. For each of the motors 32, there is a corresponding support seat arranged on the support beam 53. Each support seat consists of two support columns 54 extending vertically, which are opposite to and spaced from each other. A support plate 55 is fixed to each of the support columns 54. The support plate 55 is configured as an arc-shaped plate. Two support plates 55 opposite to each other can be used to clamp a corresponding motor 32 therebetween. In addition, a rubber pad (not shown) may be provided between the support plates 55 and the motor 32. With this arrangement, a casing of the cooling fan 31 can be separate from the motors 32, thereby increasing the overall rigidity of the cooling device 100 and also reducing the structural noise thereof. In addition, in order to further reduce aerodynamic noise, inner walls of the casing of the cooling fan 31, except that with the air outlet, are provided with sound-absorbing cotton (not shown). Field tests show that with the above arrangement, aerodynamic noise can be reduced by at least 2dB in operation.

In structure, the converter radiator 11 is in communication with more than one cooling fan 31, in order to ensure the safety of heat dissipation of the converter radiator 11. Even if one of the cooling fans 31 is damaged, other cooling fans 31 can be still in operation to dissipate heat for the converter radiator 11. Specifically, in one example, the converter radiator 11 has a longitudinal size which is about one and a half of that of the cooling fan 31. Accordingly, heat can be dissipated from the converter radiator 11 through two different cooling fans 31. With this arrangement, it not only ensures the heat dissipation efficiency, but also ensures the reasonability of the space layout.

The converter radiator 11 and the fuel cell radiator 21 may have fins formed as sawtooth sheets, so as to improve heat transfer efficiency, reduce their external dimensions, and lighten their own weight.

As shown in Fig. 1, the cooling device 100 further includes a filter 9, which is arranged on the pipeline downstream of the converter radiator 11 to filter the coolant entering the converter 200, so as to improve the safety and service life of the converter. In addition, a valve is provided at each of the openings or the inlets of pipelines of the cooling device 100, so as to facilitate to control the opening or closing of corresponding pipelines.

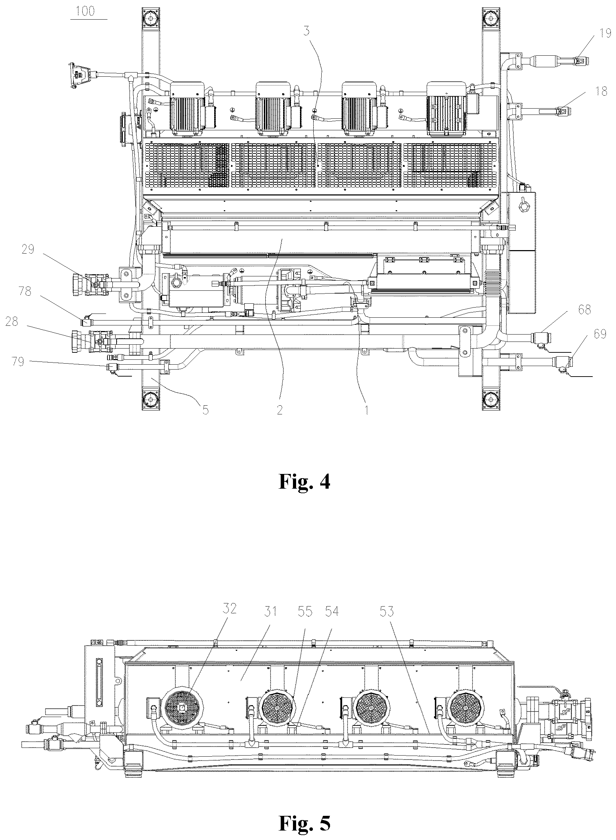

It should note that the directional terms "transverse" and "longitudinal" in the context are based on the orientation of the train itself. That is, the term "transverse" is consistent with the front-rear direction in Fig. 4, while the term "longitudinal" is consistent with the right-left direction in Fig. 4. For convenience, terms such as "first", "second" or the like are used. Specifically, the term "first end" indicates the left end in Fig. 4, and the term "second end" indicates the right end in Fig. 4. In addition, the term "first side" indicates the lower side in Fig. 4, and the term "second side" indicates the upper side in Fig. 4.

The foregoing merely introduces preferred embodiments of the present invention, which by no means restrict the scope of protection of the present invention. Within the technical scope disclosed by the present invention, one skilled in the art can readily make changes or modifications thereon, which should be considered as falling within the scope of protection of the present invention. Therefore, the scope of protection of the present invention should be determined according to the appending claims.

## Claims

1. A cooling device (100), comprising:
a converter cooling circuit (1), in which a converter radiator (11) is arranged;
a fuel cell cooling circuit (2), in which a fuel cell radiator (21) is arranged; and
an air-cooling assembly (3) configured to perform heat dissipation and cooling for the converter radiator (11) and the fuel cell radiator (21),
wherein the converter cooling circuit (1) is configured to dissipate heat for a converter (200), and the fuel cell cooling circuit (2) is configured to dissipate heat for a fuel cell (300);
wherein in a transverse direction, the converter radiator (11) is located at a first side of the fuel cell radiator (21) and in parallel therewith,
while the air-cooling assembly (3) is located at a second side of the fuel cell radiator (21),
wherein the converter radiator (11) and the fuel cell radiator (21) being partially overlapped with each other in the transverse direction;
wherein in a longitudinal direction, the converter radiator (11) is located at a second end of the fuel cell radiator (21), so that ambient air is sucked in from a first side of the converter radiator (11) at a position corresponding to the converter radiator (11), and then drawn out by the air-cooling assembly (3) after passing through the fuel cell radiator (21);
wherein in the transverse direction, the converter radiator (11) and the fuel cell radiator (21) are spaced from each other so that a cylindrical air duct body (4) is arranged between the converter radiator (11) and the fuel cell radiator (21) and in communication with both; and a cleaning port (41) is formed in an upper surface of the air duct body (4), and a cleaning cover (42) is arranged at the cleaning port (41) via a hinge; and
wherein the upper surface of the air duct body (4) is configured as an inclined surface, which has a first side and a second side higher than the first side.

2. The cooling device (100) according to claim 1, wherein the fuel cell cooling circuit (2) further comprises:
a longitudinally extending first fuel cell pipe (22), which is arranged upstream of the fuel cell radiator;
a transversely extending second fuel cell pipe (23), which is in communication with the first fuel cell pipe (22);
a transversely extending third fuel cell pipe (25), which is arranged downstream of the fuel cell radiator (21);
a longitudinally extending fourth fuel cell pipe (26), which is in communication with the third fuel cell pipe (25); and
a fuel cell water tank (24) connected in parallel with the fuel cell radiator (21),
wherein an opening (28) at the first end of the first fuel cell pipe (22) is in communication with an outlet of the fuel cell (300), and an opening (29) at the first end of the fourth fuel cell pipe (26) is communication with an inlet of the fuel cell (300), the fuel cell water tank (24) being located at the second end of the fuel cell radiator (21).

3. The cooling device (100) according to claim 2, wherein a first air conditioner pipe (61) is connected to the first fuel cell pipe (22) or the second fuel cell pipe (23), and a second air conditioner pipe (62) is connected to the first fuel cell pipe (22) or the second fuel cell pipe (23) at a position downstream of a connection between the first air conditioner pipe (61) and the first fuel cell pipe (22) or the second fuel cell pipe (23); and
the first air conditioner pipe (61) is in communication with an inlet of an air conditioner (400), and the second air conditioner pipe (62) is in communication with an outlet of the air conditioner (400).

4. The cooling device (100) according to claim 2 or 3, wherein the converter cooling circuit (1) further comprises a converter water tank (12) and a converter water pump (13), and wherein:
the converter water tank (12) is located at the first side of the fuel cell radiator (21) along the transverse direction, and at the first end of the converter radiator (11) along the longitudinal direction; and
the converter water pump (13) is located at the first side of the fuel cell radiator (21) along the transverse direction, and between the converter water tank (12) and the converter radiator (11) along the longitudinal direction.

5. The cooling device (100) according to any one of claims 1 to 4, wherein a reactor upstream pipeline (71) is arranged in parallel on a pipeline of the converter cooling circuit (1) upstream of the converter radiator (11), for connecting with an outlet of a reactor (500); and
a reactor downstream pipeline (72) is arranged in parallel on a pipeline of the converter cooling circuit (1) downstream of the converter radiator (11), for connecting with an inlet of the reactor (500).

6. The cooling device (100) according to any one of claims 1 to 5, wherein the air-cooling assembly (3) comprises multiple cooling fans (31) arranged in parallel, each cooling fan (31) being driven by a corresponding motor (32) located at the second side in the transverse direction, said multiple cooling fans (31) being arranged in sequence in the longitudinal direction, and
the converter radiator (11) is communication with more than one cooling fan (31).

7. The cooling device (100) according to claim 6, wherein sound-absorbing cotton is provided on each of inner walls of a casing of the cooling fan (31) except that with an air outlet.

8. The cooling device (100) according to claim 6 or 7, further comprising a mounting frame (5) having a longitudinally extending support beam (51) connected to the motors (32), wherein the converter cooling circuit (1), the fuel cell cooling circuit (2) and the cooling fans (31) are all fixed by the mounting frame (5).

## Patentansprüche

1. Kühlvorrichtung (100); bestehend aus:
einem Wandler-Kühlkreislauf (1); in dem ein Wandler-Kühlstrahler (11) angeordnet ist;
einem Brennstoffzellen-Kühlkreislauf (2); in dem ein Brennstoffzellen-Kühlstrahler (21) angeordnet ist; und
eine Luftkühlungsbaugruppe (3), die konfiguriert ist, um Wärmeableitung und Kühlung für den Wandler-Kühlstrahler (11) und den Brennstoffzellen-Kühlstrahler (21) auszuführen;
wobei der Wandler-Kühlkreislauf (1) zur Abführung von Wärme für einen Wandler (200) konfiguriert ist; und der Brennstoffzellen-Kühlkreislauf (2) zur Wärmeableitung für eine Brennstoffzelle (300) konfiguriert ist;
wobei in einer Querrichtung der Wandler-Kühlstrahler (11) an erster Seite des Brennstoffzellen-Kühlstrahlers (21) und parallel dazu angeordnet ist,
während die Luftkühlungsbaugruppe (3) auf einer zweiten Seite des Brennstoffzellen-Kühlstrahlers (21) angeordnet ist,
wobei der Wandler-Kühlstrahler (11) und der Brennstoffzellen-Kühlstrahler (21) teilweise miteinander in Querrichtung überlappt sind;
wobei in einer Längsrichtung der Wandler-Kühlstrahler (11) an einem zweiten Ende des Brennstoffzellen-Kühlstrahlers (21) angeordnet ist, so dass Umgebungsluft von einer ersten Seite des Wandler-Kühlstrahlers (11) an einer dem Wandler-Kühlstrahler (11) entsprechenden Position angesaugt wird; und nach dem Passieren durch den Brennstoffzellen-Kühlstrahler (21) dann von der Luftkühlungsanordnung (3) abgesaugt wird;
wobei in der Querrichtung der Wandler-Kühlstrahler (11) und der Brennstoffzellen-Kühlstrahler (21) beabstandet voneinander sind, so dass ein zylindrischer Luftkanalkörper (4) zwischen dem Wandler-Kühlstrahler (11) und dem Brennstoffzellen-Kühlstrahler (21) angeordnet und in Verbindung mit beiden ist; und eine Reinigungsöffnung (41) ist in einer oberen Fläche des Luftkanalkörpers (4); gebildet ist, und an der Reinigungsöffnung (41) ein Reinigungsdeckel (42) über ein Scharnier angeordnet ist; und
wobei die obere Fläche des Luftkanalkörpers (4) als eine geneigte Fläche konfiguriert ist, die eine erste Seite und eine zweite Seite aufweist, die höher als die erste Seite ist.

2. Kühlvorrichtung (100) nach Anspruch 1, wobei der Brennstoffzellen-Kühlkreislauf (2) weiterhin aufweist:
ein längs erstreckendes, erstes Brennstoffzellenrohr (22), das stromaufwärts von dem Brennstoffzellen-Kühlstrahler angeordnet ist;
ein quer erstreckendes, zweites Brennstoffzellenrohr (23), das in Verbindung mit dem ersten Brennstoffzellenrohr (22) steht;
ein quer erstreckendes, drittes Brennstoffzellenrohr (25), das stromabwärts von dem Brennstoffzellen-Kühlstrahler (21) angeordnet ist;
ein sich längs erstreckendes viertes Brennstoffzellenrohr (26), das in Verbindung mit dem dritten Brennstoffzellenrohr (25) steht; und
einen Brennstoffzellen-Wassertank (24), der parallel zum Brennstoffzellen-Kühlstrahler (21) verbunden ist,
wobei sich eine Öffnung (28) am ersten Ende des ersten Brennstoffzellenrohrs (22) in Verbindung mit einem Auslass der Brennstoffzelle (300) ist und eine Öffnung (29) am ersten Ende des vierten Brennstoffzellenrohrs (26) in Verbindung mit einem Einlass der Brennstoffzelle (300) ist, wobei sich der Brennstoffzellen-Wassertank (24) am zweiten Ende des Brennstoffzellen-Kühlstrahlers (21) angeordnet ist.

3. Kühlvorrichtung (100) nach Anspruch 2, wobei ein erstes Klimaanlagenrohr (61) mit dem ersten Brennstoffzellenrohr (22) oder dem zweiten Brennstoffzellenrohr (23) verbunden ist,
und ein zweites Klimaanlagenrohr (62) mit dem ersten Brennstoffzellenrohr (22) oder dem zweiten Brennstoffzellenrohr (23) an einer Position stromabwärts von einer Verbindung zwischen ersten Klimaanlagenrohr (61) und dem erste Brennstoffzellenrohr (22) oder dem zweiten Brennstoffzellenrohr (23) verbunden ist; und das erste Klimaanlagenrohr (61) ist in Verbindung mit einem Einlass der Klimaanlage (400) und das zweite Klimaanlagenrohr (62) ist in Verbindung mit einem Auslass der Klimaanlage (400).

4. Kühlvorrichtung (100) nach Anspruch 2 oder 3, wobei der Wandler-Kühlkreislauf (1) weist weiterhin einen Wandler-Wassertank (12) und eine Wandler-Wasserpumpe (13) auf, und wobei:
der Wandler-Wassertank (12) auf der ersten Seite des Brennstoffzellen-Kühlstrahlers (21) entlang der Querrichtung und am ersten Ende des Wandler-Kühlstrahlers (11) entlang der Längsrichtung angeordnet ist; und
die Wandler-Wasserpumpe (13) auf der ersten Seite des Brennstoffzellen-Kühlstrahlers (21) entlang der Querrichtung und zwischen dem Wandler-Wassertank (12) und den Wandler-Kühlstrahler (11) entlang der Längsrichtung angeordnet ist.

5. Kühlvorrichtung (100) nach irgendeinem der Ansprüche 1 bis 4, wobei ein dem Induktor vorgeschaltete Rohrleitung (71) parallel an einer Rohrleitung des Wandler-Kühlkreislauf (1) vorgeschaltet dem Wandler-Kühlstrahler (11) zum Verbinden mit einem Auslass eines Induktors (500) angeordnet ist; und
eine dem Reaktor nachgeschaltete Rohrleitung (72) ist parallel an eine Rohrleitung des Wandler-Kühlkreislaufs (1) stromabwärts des Wandler-Kühlstrahlers (11) zum Verbinden mit einem Einlass des Induktors (500) angeordnet.

6. Kühlvorrichtung (100) nach irgendeinem der Ansprüche 1 bis 5, wobei die Luftkühlungsanordnung (3) mehrere parallel angeordnete Kühlventilatoren (31) aufweist, wobei jeder Kühlventilator (31) von einem entsprechenden Motor (32) angetrieben wird, der an der zweiten Seite in Querrichtung angeordnet ist, wobei mehrere Kühlventilatoren (31) in Längsrichtung der Reihe nach angeordnet sind, und
der Wandler-Kühlstrahler (11) mit mehr als einem Kühlventilator (31) in Verbindung steht.

7. Kühlvorrichtung (100) nach Anspruch 6, wobei schallabsorbierende Baumwolle an jeder der Innenwände des Gehäuses des Kühlventilators (31) vorgesehen ist, ausgenommen die mit einem Luftauslass.

8. Kühlvorrichtung (100) nach Anspruch 6 oder 7, die weiterhin einen Montagerahmen (5) mit einem in Längsrichtung erstreckenden Tragbalken (51) aufweist, der mit den Motoren (32) verbunden ist, wobei der Wandler-Kühlkreislauf (1) der Brennstoffzellenkühlkreislauf (2) und die Kühlventilatoren (31) alle durch den Montagerahmen (5) befestigt werden.

## Revendications

1. Dispositif de refroidissement (100), comprenant :
un circuit de refroidissement de convertisseur (1), dans lequel est agencé un radiateur de convertisseur (11) ;
un circuit de refroidissement de pile à combustible (2), dans lequel est agencé un radiateur de pile à combustible (21) ; et
un ensemble de refroidissement à air (3) configuré pour réaliser une dissipation de chaleur et un refroidissement pour le radiateur de convertisseur (11) et le radiateur de pile à combustible (21),
dans lequel le circuit de refroidissement de convertisseur (1) est configuré pour dissiper de la chaleur pour un convertisseur (200), et le circuit de refroidissement de pile à combustible (2) est configuré pour dissiper de la chaleur pour une pile à combustible (300) ;
dans lequel, dans une direction transversale, le radiateur de convertisseur (11) est situé sur un premier côté du radiateur de pile à combustible (21) et parallèlement à celui-ci, tandis que l'ensemble de refroidissement à air (3) est situé sur un deuxième côté du radiateur de pile à combustible (21),
dans lequel le radiateur de convertisseur (11) et le radiateur de pile à combustible (21) se chevauchent partiellement dans la direction transversale ;
dans lequel, dans une direction longitudinale, le radiateur de convertisseur (11) est situé à une deuxième extrémité du radiateur de pile à combustible (21), de sorte que de l'air ambiant soit aspiré à partir d'un premier côté du radiateur de convertisseur (11) à une position correspondant au radiateur de convertisseur (11), puis évacué par l'ensemble de refroidissement à air (3) après avoir traversé le radiateur de pile à combustible (21) ;
dans lequel, dans la direction transversale, le radiateur de convertisseur (11) et le radiateur de pile à combustible (21) sont espacés l'un de l'autre de sorte qu'un corps de conduit d'air cylindrique (4) soit agencé entre le radiateur de convertisseur (11) et
le radiateur de pile à combustible (21) et en communication avec les deux ; et un orifice de nettoyage (41) est formé dans une surface supérieure du conduit d'air cylindrique (4), et un couvercle de nettoyage (42) est agencé au niveau de l'orifice de nettoyage (41) par le biais d'une charnière ; et
dans lequel la surface supérieure du conduit d'air cylindrique (4) est configurée en tant que surface inclinée, qui présente un premier côté et un deuxième côté plus haut que le premier côté.

2. Dispositif de refroidissement (100) selon la revendication 1, dans lequel le circuit de refroidissement de pile à combustible (2) comprend en outre :
un premier tuyau de pile à combustible s'étendant longitudinalement (22), qui est agencé en amont du radiateur de pile à combustible,
un deuxième tuyau de pile à combustible s'étendant transversalement (23), qui est en communication avec le premier tuyau de pile à combustible (22) ;
un troisième tuyau de pile à combustible s'étendant transversalement (25), qui est agencé en aval du radiateur de pile à combustible (21) ;
un quatrième tuyau de pile à combustible s'étendant longitudinalement (26), qui est en communication avec le troisième tuyau de pile à combustible (25) ; et
un réservoir d'eau de pile à combustible (24) raccordé en parallèle au radiateur de pile à combustible (21),
dans lequel une ouverture (28) à la première extrémité du premier tuyau de pile à combustible (22) est en communication avec une sortie de la pile à combustible (300), et une ouverture (29) à la première extrémité du quatrième tuyau de pile à combustible (26) est en communication avec une entrée de la pile à combustible (300), le réservoir d'eau de pile à combustible (24) étant situé à la deuxième extrémité du radiateur de pile à combustible (21).

3. Dispositif de refroidissement (100) selon la revendication 2, dans lequel un premier tuyau de climatiseur (61) est raccordé au premier tuyau de pile à combustible (22) ou au deuxième tuyau de pile à combustible (23), et un deuxième tuyau de climatiseur (62) est raccordé au premier tuyau de pile à combustible (22) ou au deuxième tuyau de pile à combustible (23) à une position en aval d'un raccordement entre le premier tuyau de climatiseur (61) et le premier tuyau de pile à combustible (22) ou le deuxième tuyau de pile à combustible (23) ; et
le premier tuyau de climatiseur (61) est en communication avec une entrée d'un climatiseur (400), et le deuxième tuyau de climatiseur (62) est en communication avec une sortie du climatiseur (400).

4. Dispositif de refroidissement (100) selon la revendication 2 ou 3, dans lequel le circuit de refroidissement de convertisseur (1) comprend en outre un réservoir d'eau de convertisseur (12) et une pompe à eau de convertisseur (13), et dans lequel :
le réservoir d'eau de convertisseur (12) est situé sur le premier côté du radiateur de pile à combustible (21) le long de la direction transversale, et à la première extrémité du radiateur de convertisseur (11) le long de la direction longitudinale ; et
la pompe à eau de convertisseur (13) est située sur le premier côté du radiateur de pile à combustible (21) le long de la direction transversale, et entre le réservoir d'eau de convertisseur (12) et le radiateur de convertisseur (11) le long de la direction longitudinale.

5. Dispositif de refroidissement (100) selon l'une quelconque des revendications 1 à 4, dans lequel une canalisation amont de réacteur (71) est agencée en parallèle sur une canalisation du circuit de refroidissement de convertisseur (1) en amont du radiateur de convertisseur (11), pour le raccordement à une sortie d'un réacteur (500) ; et
une canalisation aval de réacteur (72) est agencée en parallèle sur une canalisation du circuit de refroidissement de convertisseur (1) en aval du radiateur de convertisseur (11), pour le raccordement à une entrée du réacteur (500).

6. Dispositif de refroidissement (100) selon l'une quelconque des revendications 1 à 5, dans lequel l'ensemble de refroidissement à air (3) comprend de multiples ventilateurs de refroidissement (31) agencés en parallèle, chaque ventilateur de refroidissement (31) étant entraîné par un moteur correspondant (32) situé sur le deuxième côté dans la direction transversale, lesdits multiples ventilateurs de refroidissement (31) étant agencés en séquence dans la direction longitudinale, et
le radiateur de convertisseur (11) est en communication avec plus d'un ventilateur de refroidissement (31).

7. Dispositif de refroidissement (100) selon la revendication 6, dans lequel du coton insonorisant est disposé sur chacune des parois internes d'un carter du ventilateur de refroidissement (31) à l'exception de celle avec une sortie d'air.

8. Dispositif de refroidissement (100) selon la revendication 6 ou 7, comprenant en outre un cadre de montage (5) ayant une poutre de support s'étendant longitudinalement (51) raccordée aux moteurs (32), dans lequel le circuit de refroidissement de convertisseur (1), le circuit de pile à combustible (2) et les ventilateurs de refroidissement (31) sont tous fixés par le cadre de montage (5).
